# EUROPÄISCHE PATENTSCHRIFT

(11) **EP 2 600 378 B1**
(45) Veröffentlichungstag und Bekanntmachung des Hinweises auf die Patenterteilung: **13.05.2020**
(21) Anmeldenummer: 12195079.4
(22) Anmeldetag: 30.11.2012
(51) Int. Cl.: H01H 85/54, H01H 85/20, H01H 9/10, H01R 25/14, H01L 31/05, H01H 85/02

(54) **Schaltvorrichtung zum Schalten eines elektrischen Bauelementes in einen Strompfad**
Connection device for connecting an electric component into a current path
Dispositif de commutation d'un composant électrique dans un trajet de courant

(30) Priorität: 30.11.2011 DE 102011087492
(43) Veröffentlichungstag der Anmeldung: 05.06.2013
(73) Patentinhaber: Wöhner GmbH & Co. KG Elektrotechnische Systeme, 96472 Rödental (DE)
(72) Erfinder: Büttner, Alex, 96472 Rödental (DE)
(74) Vertreter: Isarpatent

(56) Entgegenhaltungen:
- DE-A1- 3 513 462
- DE-A1- 10 104 516
- DE-A1-102006 030 953
- DE-C- 969 624
- DE-U1-202010 003 375

## Beschreibung

Die Erfindung betrifft eine Schaltvorrichtung zum Schalten eines elektronischen Bauelementes in einen Strompfad und insbesondere eine Schaltvorrichtung zum Schalten einer Sicherung für einen Photovoltaikmodulstrang in einer Photovoltaikanlage.

In vielen Anwendungen ist es notwendig, Bauelemente in einen Strompfad zu schalten. Beispielsweise ist es notwendig, einen Strompfad gegenüber zu hohen elektrischen Strömen zu schützen, indem man eine Schmelzsicherung in den Strompfad schaltet, welche bei Auftreten eines elektrischen Überstroms schmilzt und so den Strompfad unterbricht. Hohe elektrische Ströme können elektrische Anlagen gefährden und Brände verursachen. Deshalb baut man als Überstromschutzeinrichtung beispielsweise eine Schmelzsicherung in den Stromkreis ein. Die Schmelzsicherung kann beispielsweise einen Leiter mit kleinem Querschnitt in einem feuersicheren Gehäuse aufweisen, wobei der Leiter bzw. Schmelzleiter bei Auftreten eines elektrischen Überstromes schmilzt. Der Schmelzeinsatz der Schmelzsicherung besteht aus einem isolierenden Gehäuse, beispielsweise aus Glas oder Porzellan, in welches der Schmelzleiter eingebaut ist. Nach dem Ansprechen der Schmelzsicherung ist diese auszuwechseln. Nicht nur in diesem Anwendungsfall, sondern auch in vielen anderen Anwendungsfällen ist es notwendig, elektronische oder elektrische Bauelemente in einen Strompfad zu verschalten, wobei das Auswechseln der elektrischen Bauelemente in einfacher Weise zu erfolgen hat. Es sind Sicherungshalter für Zylindersicherungen bekannt, die in Zu- und Abgangsleitungen einer zu schützenden Schaltung vorgesehen werden. Derartige Sicherungshalter sind herkömmlicherweise auf Normtragschienen aufgerastet und werden mit Zu- und Abgangsleitungen üblicherweise mittels sogenannter Rahmenklemmen verdrahtet. Beispielsweise werden in einer herkömmlichen Photovoltaikanlage Photovoltaikmodulstränge, die aus mehreren in Serie verschalteten Photovoltaikmodulen bestehen, durch einen derartigen herkömmlichen Sicherungshalter abgesichert und der Summenstrom der verschiedenen Photovoltaikmodulstränge einem Wechselrichter zugeführt, welcher einen über die Stromsammelschiene fließenden Gleichstrom DC in einen Wechselstrom AC umwandelt. Eine derartige herkömmliche Photovoltaikanlage kann eine Vielzahl von Photovoltaikmodulsträngen und eine entsprechende Anzahl von Sicherungshaltern aufweisen. Die herkömmlichen Schaltvorrichtungen zum Schalten eines elektronischen Bauelementes, insbesondere einer Sicherung, wie zum Beispiel in Dokument DE 35 13 462 A1, weisen den Nachteil auf, dass sie mittels Rahmenklemmen durch einen Monteur verdrahtet werden müssen. Dazu ist die Schaltvorrichtung durch den Monteur beispielsweise mittels eines Schraubenziehers mit einer Anschlussleitung zu verdrahten. Dieser Montagevorgang ist für den Monteur insbesondere bei einer großen Anzahl von zu verdrahtenden Anschlussleitungen mühsam und zeitraubend. Darüber hinaus ist eine derartige manuelle Montage fehleranfällig.

Aus der DE 101 04 516 A1 ist eine schaltbare Sicherungsleiste für zylindrische Sicherungen bekannt. Sie dient dem direkten Aufsetzen der Sicherungsleiste auf Sammelschienen. Die Sicherungsleiste weist ein Gehäuse auf, in dem, entsprechend der Anzahl der abzusichernden Phasen, Kapselelemente gelagert sind. Jedes Kapselelement nimmt eine der Sicherungen auf. Das Kapselelement weist ein Kapselunterteil, das ausschließlich schwenkbar im Gehäuse gelagert ist, und ein Kapseloberteil auf. Diese sind ineinandergesteckt. Die Sicherung steht durch eine Bodenöffnung des Kapselunterteils in leitender Verbindung mit einem gehäuseseitigen ersten Kontakt sowie im Kapseloberteil in leitender Verbindung mit einem zweiten Kontakt. Durch Schwenken des Kapselelementes zwecks Schalten ist der zweite Kontakt in leitende Verbindung mit einem gehäuseseitigen, dritten Kontakt bringbar. An dem Gehäuse der schaltbaren Sicherungsleiste sind des Weiteren Haken angeordnet, die dem Aufstecken auf die horizontal angeordneten Sammelschienen eines Sammelschienensystems dienen.

Es ist daher eine Aufgabe der vorliegenden Erfindung, eine Schaltvorrichtung zum Schalten eines elektronischen Bauelementes in einen Strompfad zu schaffen, dessen Montage besonders einfach und fehlerresistent ist.

Diese Aufgabe wird erfindungsgemäß durch eine Schaltvorrichtung mit den im Patentanspruch 1 angegebenen Merkmalen gelöst.

Die Erfindung schafft demnach eine Schaltvorrichtung zum Schalten eines elektronischen Bauelementes in einen Strompfad, wobei die Schaltvorrichtung aufweist:
- ein Gehäuse mit einer Arretiereinrichtung zum Aufrasten des Gehäuses auf einer Stromsammelschiene;
- eine schwenkbare Halteeinrichtung, in welcher das elektrische Bauelement einsetzbar und durch Schwenken der Halteeinrichtung in den Strompfad schaltbar ist; und
- eine einzelne Anschlussklemme, die über das in den Strompfad geschaltete elektrische Bauelement direkt mit mindestens einem an dem Gehäuse vorgesehenen Federkontakt verbunden ist, welcher in einem aufgerasteten Zustand des Gehäuses an der Stromsammelschiene anliegt.

Bei einer möglichen Ausführungsform der erfindungsgemäßen Schaltvorrichtung drückt in dem aufgerasteten Zustand des Gehäuses eine Feder den Federkontakt gegen die Stromsammelschiene.

Bei einer möglichen Ausführungsform der erfindungsgemäßen Schaltvorrichtung ist die Feder eine Blattfeder

Bei einer möglichen Ausführungsform der erfindungsgemäßen Schaltvorrichtung ist der Federkontakt L-förmig.

Bei einer möglichen alternativen Ausführungsform der erfindungsgemäßen Schaltvorrichtung ist der Federkontakt U-förmig ist.

Bei einer weiteren möglichen Ausführungsform der erfindungsgemäßen Schaltvorrichtung ist die Anschlussklemme eine Rahmenklemme.

Bei einer alternativen Ausführungsform der erfindungsgemäßen Schaltvorrichtung ist die Anschlussklemme eine Federzugsklemme.

Bei einer möglichen Ausführungsform der erfindungsgemäßen Schaltvorrichtung ist das elektronische Bauelement eine Schmelzsicherung.

Bei einer weiteren möglichen Ausführungsform der erfindungsgemäßen Schaltvorrichtung weist die Arretiereinrichtung mindestens eine Zunge auf, die durch mindestens zwei im Wesentlichen parallel verlaufende Rippen an das Gehäuse der Schaltvorrichtung angeformt ist.

Bei einer weiteren möglichen Ausführungsform der erfindungsgemäßen Schaltvorrichtung liegt der Federkontakt in dem aufgerasteten Zustand des Gehäuses an einen Seitenabschnitt der Stromsammelschiene an.

Bei einer alternativen Ausführungsform der erfindungsgemäßen Schaltvorrichtung liegt der Federkontakt in dem aufgerasteten Zustand des Gehäuses an einer Oberseite der Stromsammelschiene an.

Bei einer weiteren möglichen Ausführungsform der erfindungsgemäßen Schaltvorrichtung besteht der Federkontakt aus einem federnden leitfähigen Material.

Bei einer weiteren möglichen Ausführungsform der erfindungsgemäßen Schaltvorrichtung ist an die Anschlussklemme der Schaltvorrichtung ein Photovoltaik-Modul-Strang von seriell verschalteten Photovoltaikmodulen angeschlossen, die bei Lichteinstrahlung einen elektrischen Gleichstrom erzeugen.

Bei einer möglichen Ausführungsform der erfindungsgemäßen Schaltvorrichtung bildet die Stromsammelschiene einen Summenstromknoten für eine Vielzahl von Photovoltaik-Modul-Strängen, die jeweils über eine Schaltvorrichtung mit der Stromsammelschiene verbunden sind, so dass auf der Stromsammelschiene die erzeugten Gleichströme der Photovoltaik-Modul-Stränge zu einem Summenstrom aufsummiert werden.

Bei einer weiteren möglichen Ausführungsform der erfindungsgemäßen Schaltvorrichtung ist die Stromsammelschiene an einen Wechselrichter angeschlossen, welcher einen über der Stromsammelschiene fließenden Summen-Gleichstrom in einen Wechselstrom umwandelt.

Bei einer weiteren möglichen Ausführungsform der erfindungsgemäßen Schaltvorrichtung ist die Stromsammelschiene an einen Überspannungsschutz angeschlossen.

Die Erfindung schafft ferner eine Photovoltaikanlage mit mehreren Photovoltaik-Modul-Strängen, die jeweils seriell verschaltete Photovoltaik-Module aufweisen, die bei Lichteinstrahlung einen elektrischen Gleichstrom erzeugen, wobei jeder Photovoltaik-Modul-Strang an einer Anschlussklemme einer zugehörigen Schaltvorrichtung angeschlossen ist, welche aufweist:
- ein Gehäuse mit einer Arretiereinrichtung zum Aufrasten des Gehäuses auf einer Stromsammelschiene der Photovoltaikanlage;
- eine schwenkbare Halteeinrichtung, in welcher das elektrische Bauelement einsetzbar und durch Schwenken der Halteeinrichtung in den Strompfad schaltbar ist;
- wobei die Anschlussklemme über das in den Strompfad geschaltete elektrische Bauelement direkt mit mindestens einem an dem Gehäuse vorgesehenen Federkontakt verbunden ist, welcher in einem aufgerasteten Zustand des Gehäuses an der Stromsammelschiene der Photovoltaikanlage anliegt.

Bei einer möglichen Ausführungsform der erfindungsgemäßen Photovoltaikanlage weist diese eine Vielzahl von Schaltvorrichtungen zum Schalten eines elektrischen Bauelementes in einen oder mehrere Strompfade auf, wobei es sich bei den elektrischen Bauelementen um Sicherungen, insbesondere Schmelzsicherungen, handelt.

Bei einer weiteren möglichen Ausführungsform der erfindungsgemäßen Photovoltaikanlage ist die Stromsammelschiene an einen Wechselrichter angeschlossen, welcher einen über die Stromsammelschiene fließenden Summen-Gleichstrom, welcher die Summe aller durch die Photovoltaik-Modul-Stränge erzeugten Gleichströme bildet, in einen Wechselstrom umwandelt.

Im Folgenden werden mögliche Ausführungsformen der erfindungsgemäßen Vorrichtung zum Schalten eines elektronischen Bauelementes in einen Strompfad einer erfindungsgemäßen Photovoltaikanlage, welche derartige Schaltvorrichtungen verwendet, unter Bezugnahme auf die beigefügten Figuren näher erläutert.

Es zeigen:
- Fig. 1: eine Querschnittsansicht für ein Ausführungsbeispiel einer erfindungsgemäßen Schaltvorrichtung zum Schalten eines elektronischen Bauelementes in einen Strompfad;
- Fig. 2A, 2B: Ansichten zur Darstellung eines Austausches eines elektronischen Bauelementes bei der in Fig. 1 dargestellten Schaltvorrichtung;
- Fig. 3: eine Querschnittsansicht durch die in Fig. 1 dargestellte Schaltvorrichtung zur Erläuterung eines Stromflusses durch die Schaltvorrichtung;
- Fig. 4: ein Blockschaubild eines Ausführungsbeispiels für eine erfindungsgemäße Photovoltaikanlage, die Schaltvorrichtungen gemäß der Erfindung verwendet.

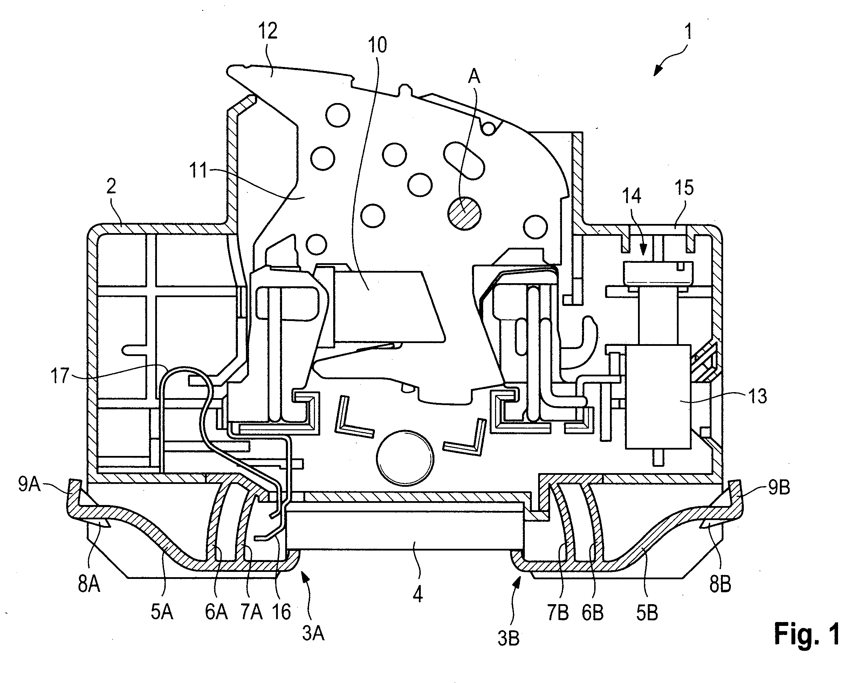

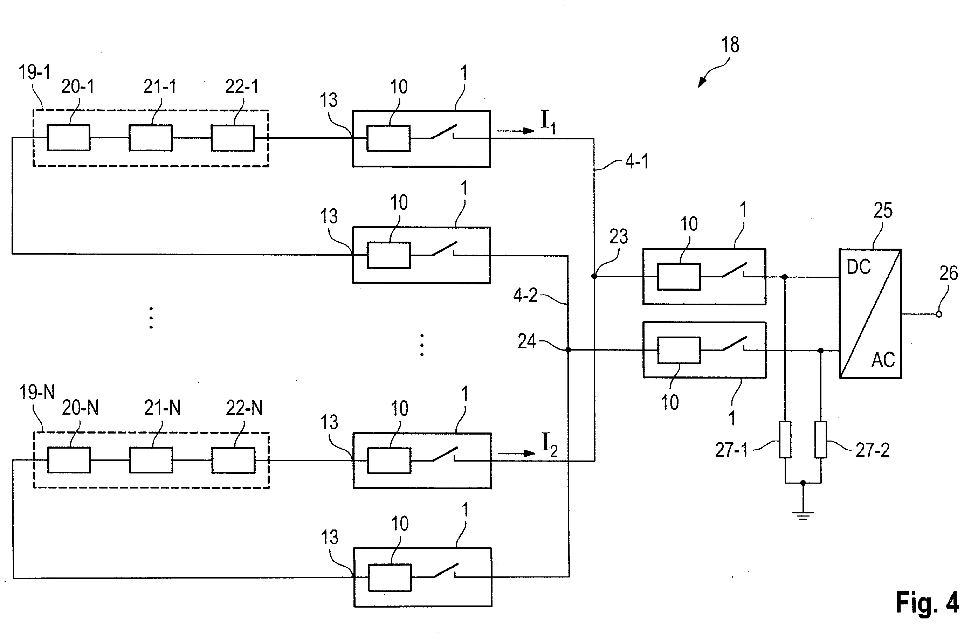

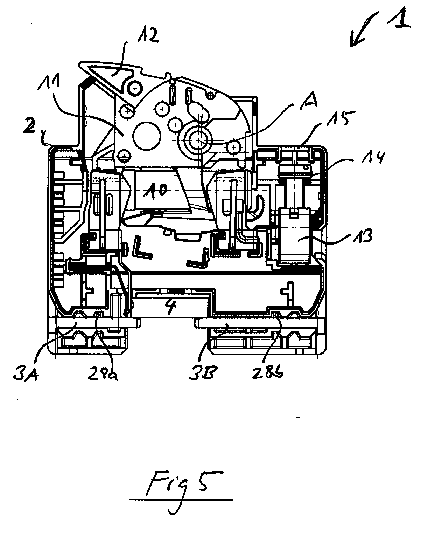

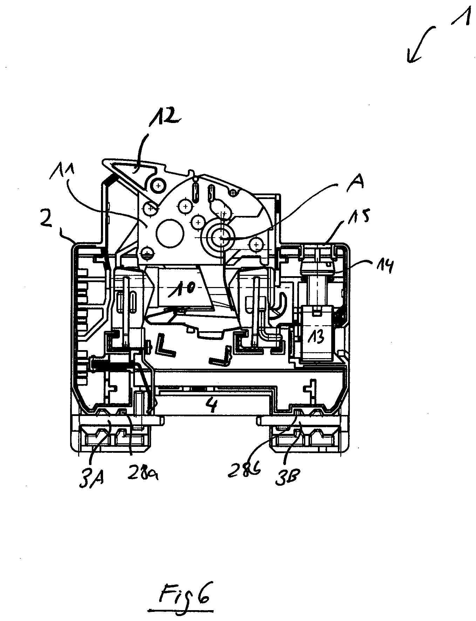

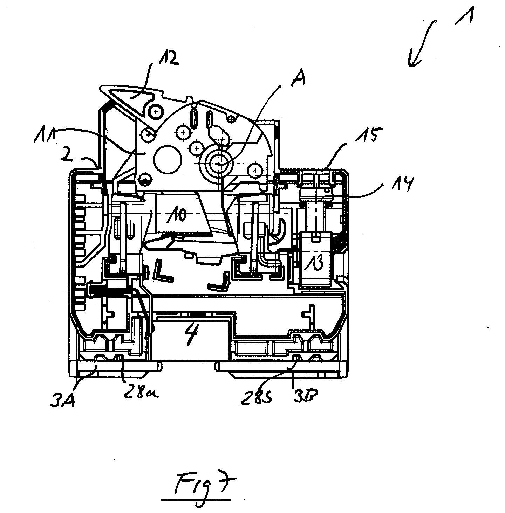

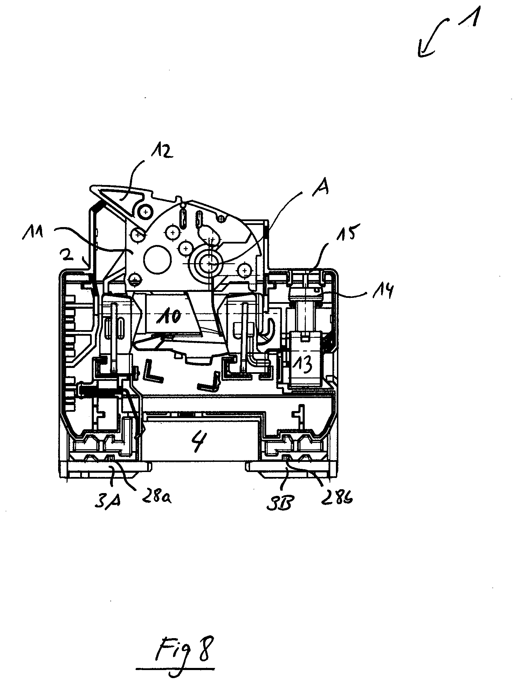

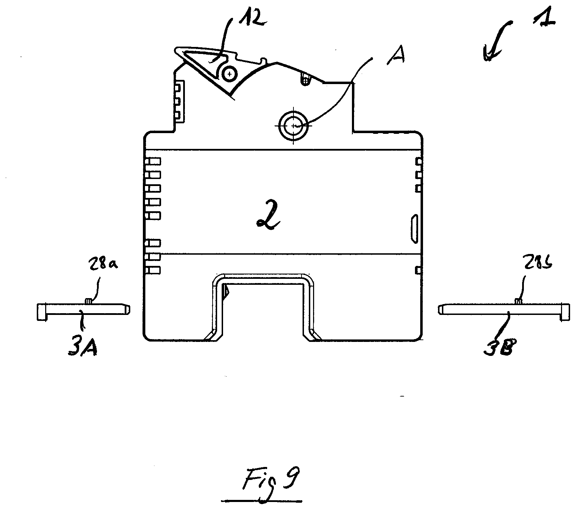

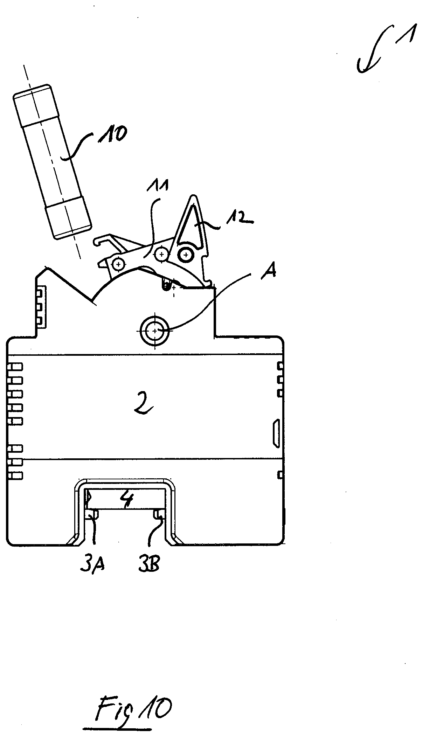

Wie man aus der Querschnittsansicht gemäß Fig. 1 erkennen kann, weist bei dem dargestellten Ausführungsbeispiel die Schaltvorrichtung 1 ein Gehäuse 2 auf. In Fig. 1 ist eine Gehäusewandung des Gehäuses 2 dargestellt. An der Unterseite des Gehäuses 2 befindet sich, wie in Fig. 1 gezeigt, wenigstens eine Arretiereinrichtung 3 zum Aufrasten des Gehäuses 2 auf einer Stromsammelschiene 4. Jede der beiden in Fig. 1 dargestellten Arretiereinrichtungen 3A, 3B weist eine Zunge 5A, 5B auf, die jeweils durch mindestens zwei im Wesentlichen parallel verlaufende Rippen 6A, 6B; 7A, 7B an das Gehäuse 2 der Schaltvorrichtung 1 angeformt ist. Weiterhin kann die Arretiereinrichtung 3A, 3B jeweils einen Rastabschnitt 8A, 8B und einen Betätigungsabschnitt 9A, 9B aufweisen. Die Stromsammelschiene 4 besteht aus einem stromleitfähigen Material zum Leiten von Strom, wobei die Stromsammelschiene 4 gleichzeitig als Trageschiene zum Halten bzw. Sichern der Schaltvorrichtung 1 dient. Die Arretiereinrichtung 3A, 3B mit den Rippen 6A, 6B, 7A, 7B sowie der Zunge 5A, 5B kann aus einem flexiblen Material mit federnden Eigenschaften bestehen. Die Zunge 5A, 5B ist, wie in Fig. 1 dargestellt, beispielsweise S-förmig gebogen. Das in Fig. 1 dargestellte Gehäuse 2 kann bei einer möglichen Ausführungsform aus zwei Gehäuseschalenhälften zusammengesetzt sein. Dabei sind die Rippen 6A, 6B, 7A, 7B und die Zungen 5A, 5B der Arretiereinrichtungen 3A, 3B bei einer möglichen Ausführungsform an einer der beiden Gehäuseschalenhälften angeformt. Der Abstand zwischen den beiden Arretiereinrichtungen 3A, 3B, wie sie in Fig. 1 dargestellt sind, entspricht der Breite der Stromsammelschiene 4, wobei die Spitzen der Zungen 5A, 5B in dem aufgerasteten Zustand gemäß Fig. 4 jeweils die Stromsammelschiene 4 umgreifen, so dass die erfindungsgemäße Schaltvorrichtung 1 fest auf der Stromsammelschiene 4 im eingerasteten bzw. aufgerasteten Zustand sitzt. An dem Betätigungsabschnitt 9A, 9B ist jeweils ein Rastabschnitt 8A, 8B vorgesehen. Das dem Betätigungsabschnitt 9A, 9B gegenüberliegende Ende der jeweiligen Zunge 5A, 5B ist hakenförmig nach oben gezogen und dient als Arretierabschnitt zur Arretierung der Schaltvorrichtung 1 auf der in Fig. 1 dargestellten Tragschiene bzw. Stromsammelschiene 4.

Zum De-Arretieren bzw. Lösen des Gehäuses 2 von der Stromsammelschiene 4 wird die Arretiereinrichtung 3A, 3B nach außen bewegt. Dies ist möglich, da die Arretiereinrichtungen 3A, 3B über die Rippen 6A, 6B, 7A, 7B elastisch bzw. federnd mit dem Gehäuse 2 der Schaltvorrichtung 1 verbunden sind. Die in Fig. 1 dargestellte Ausführungsform weist zwei Arretiereinrichtungen 3A, 3B auf. Alternativ kann die Schaltvorrichtung 1 auch nur eine Arretiereinrichtung 3 aufweisen, beispielsweise die Arretiereinrichtung 3A.

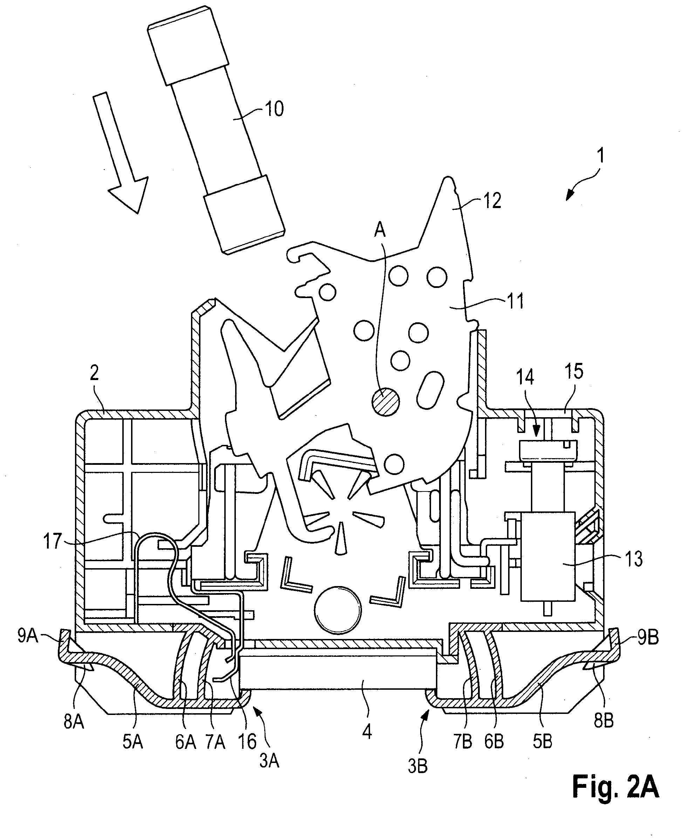

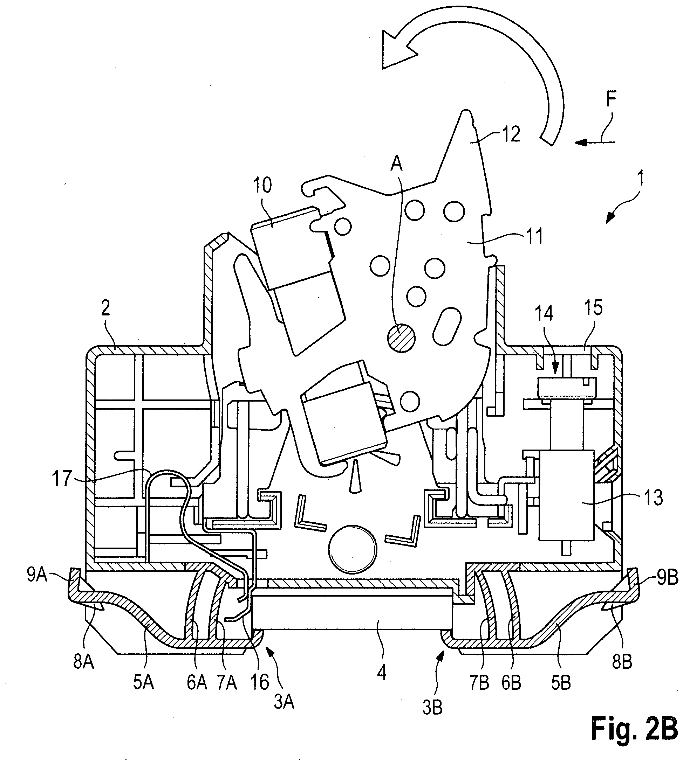

Die in Fig. 1 dargestellte Schaltvorrichtung 1 dient zum Schalten eines elektrischen Bauelementes 10, bei dem es sich beispielsweise um eine elektronische Sicherung oder dergleichen handeln kann. Die Schaltvorrichtung 1 verfügt ferner über eine schwenkbare Halteeinrichtung bzw. einen Sicherungshalter 11, welcher manuell betätigbar ist. In die schwenkbare Halteeinrichtung 11 wird das elektrische Bauelement bzw. die Sicherung 10 eingesetzt und durch Schwenken der Halteeinrichtung 11 in einen Strompfad geschaltet. Dies ist anschaulich in den Fig. 2A, 2B dargestellt.

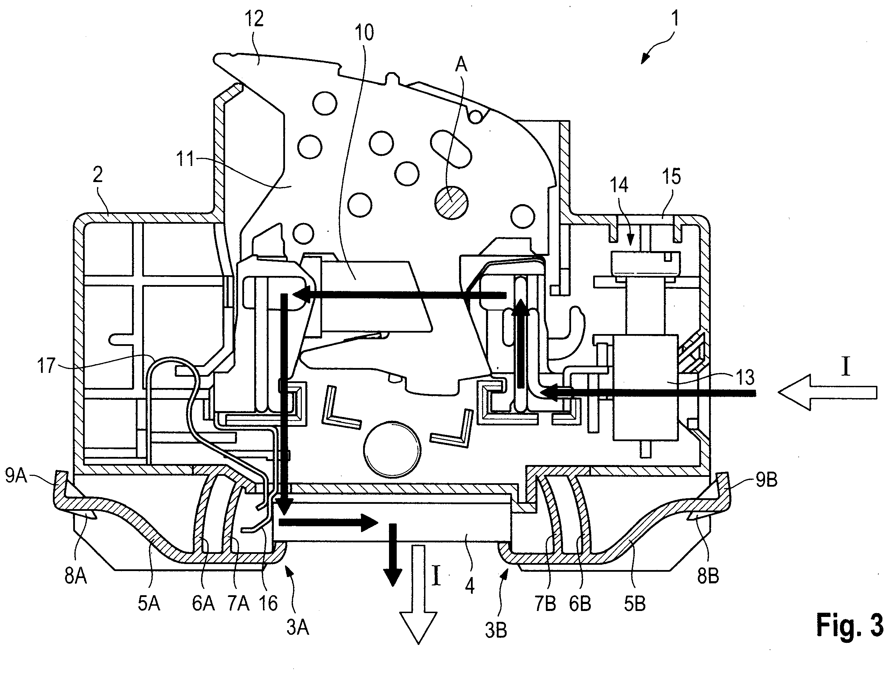

Wie man in Fig. 2A erkennen kann, dient die schwenkbare Halteeinrichtung 11 zur Aufnahme eines elektrischen Bauelementes 10. Bei dem elektrischen Bauelement 10 handelt es sich in dem dargestellten Ausführungsbeispiel um eine Sicherung, insbesondere um eine Schmelzsicherung. Alternativ kann es sich bei dem elektrischen Bauelement 10 auch um ein anderes elektrisches Bauelement handeln, beispielsweise um einen einsetzbaren Widerstand, einen einsetzbaren Kondensator oder eine einsetzbare Induktivität. Nach Einsetzen des elektrischen bzw. elektronischen Bauelementes 10 in die schwenkbare Halteeinrichtung 11 kann durch Betätigen der Halteeinrichtung 11 diese aus der in den Fig. 2A, 2B dargestellten Stellung in die Stellung gemäß Fig. 1 verbracht werden. Hierzu wird, wie in Fig. 2B dargestellt, eine Kraft F auf einen Betätigungsabschnitt 12 der Halteeinrichtung 11 ausgeübt. Durch Schwenken der Halteeinrichtung 11 wird das elektrische Bauelement 10 in einen Strompfad geschaltet, wie in Fig. 3 verdeutlicht.

Die in Fig. 1 dargestellte Schaltvorrichtung 1 weist eine Anschlussklemme 13 auf. Bei dem in Fig. 1 dargestellten Ausführungsbeispiel handelt es sich bei der Anschlussklemme 13 um eine Rahmenklemme, mit deren Hilfe ein Anschlusskabel bzw. ein Anschlussdraht mit Hilfe einer Klemmschraube 14 an die Schaltvorrichtung 1 angeschlossen werden kann. Die Klemmschraube 14 ist über eine in dem Gehäuse 2 der Schaltvorrichtung 1 vorgesehene Öffnung 15 mit Hilfe eines Werkzeuges, insbesondere eines Schraubenziehers, betätigbar. Wie in Fig. 1 dargestellt, befindet sich der Kopf der Klemmschraube 14 innerhalb des Gehäuses 2, so dass er nicht durch eine Person berührt werden kann. Alternativ kann die Anschlussklemme 13 auch als Federzugsklemme ausgebildet sein, in die ein Anschlussdraht einrasten kann. Die Anschlussklemme 13 ist über das in den Strompfad geschaltete elektrische Bauelement 10 direkt mit mindestens einem in dem Gehäuse 2 vorgesehenen Federkontakt 16 verbunden, welcher in dem in Fig. 1 dargestellten aufgerasteten Zustand des Gehäuses 2 direkt an der Stromsammelschiene 4 anliegt. Dabei wird der Federkontakt 16 gegen die Stromsammelschiene 4 gedrückt, um einen elektrischen Kontakt herzustellen. Der Federkontakt 16 besteht ebenfalls aus einem stromleitfähigen Material. Bei der in Fig. 1 dargestellten Ausführungsform verfügt die Schaltvorrichtung 1 ferner über mindestens eine Feder 17, welche den Federkontakt 16 gegen die Stromsammelschiene 4 im eingerasteten bzw. aufgerasteten Zustand der Schaltvorrichtung 1 mechanisch drückt. Bei der Feder 17 kann es sich, wie in Fig. 1 dargestellt, um eine Blattfeder handeln. Alternativ kann es sich bei der Feder 17 auch um eine Feder einer anderen Federart, beispielsweise um eine Sprungfeder oder dergleichen, handeln. Mit Hilfe der Feder 17 wird der Federkontakt 16 mit einer vorgegebenen Kraft gegen die Oberfläche der Stromsammelschiene 4 gepresst bzw. gedrückt. Der Federkontakt 16 ist, wie in Fig. 1 dargestellt, an seiner Spitze im Wesentlichen L-förmig ausgebildet. Alternativ kann der Endabschnitt des Federkontakts 16 auch U-förmig ausgebildet sein und auf der innersten Rippe 7A, 7B der Arretiereinrichtung 3A, 3B aufliegen. Bei der in Fig. 1 dargestellten Ausführungsform wird der Federkontakt 16 gegen den linken Seitenabschnitt der Stromsammelschiene 4 gedrückt. Alternativ ist es auch möglich, dass zwei Federkontakte 16 gegen beide Seitenabschnitte der Stromsammelschiene 4 gedrückt werden und parallel über das elektrische Bauelement 10 an die Anschlussklemme 13 angeschlossen sind. Bei einer weiteren möglichen Ausführungsform wird der Federkontakt 16 gegen die Oberseite der Stromsammelschiene 4 im aufgerasteten Zustand gepresst bzw. gedrückt. Der Federkontakt 16 ist über eine interne Stromleitung mit einem internen Kontakt 17 verbunden, der zur Kontaktierung des eingelegten elektrischen Bauelementes 10 dient. Durch das eingelegte elektrische Bauelement 10 führt ein Strompfad ausgehend von der Anschlussklemme 13 über das eingesetzte Bauelement 10, den Kontakt 17, den Federkontakt 16 zu der Stromsammelschiene 4, wie in Fig. 3 angedeutet.

Handelt es sich bei dem elektrischen Bauelement 10 um eine Sicherung, wird mit Hilfe der erfindungsgemäßen Schaltvorrichtung 1 ein eingespeister Strom über die eingelegte Sicherung 10 direkt auf die Stromsammelschiene 4 eingespeist und kann von dort beispielsweise zentral an einen Wechselrichter geführt werden. Wie man aus Fig. 1 erkennen kann, weist die erfindungsgemäße Schaltvorrichtung 1 nur eine Klemmstelle 13 in Form einer Rahmenklemme bzw. einer Federzugsklemme auf, die über den Federkontakt 16 mit der Stromsammelschiene 4 elektrisch verbunden ist. Der Federkontakt 16 besteht aus einem elektrisch leitfähigen Material, beispielsweise Kupfer, und weist einen niedrigen Ohm'schen Widerstand auf. Weiterhin kann es sich bei dem Federkontakt 16 auch um eine Kupferlegierung handeln, die elastische Federeigenschaften aufweist. Die Stromsammelschiene 4 kann eine vorgegebene Breite und Höhe aufweisen, beispielsweise eine Höhe von 5 mm und eine Breite von 30 mm. In einer möglichen Ausführungsform entspricht der Abstand zwischen den beiden Arretiereinrichtungen 3A, 3B, wie sie in Fig. 1 dargestellt sind, der Breite der Stromsammelschiene 4. Die Stromsammelschiene 4 dient einerseits zum Transport von elektrischem Strom I und andererseits als mechanische Tragschiene für die aufgerastete Schaltvorrichtung 1. Zum Aufrasten der Schaltvorrichtung 1 auf die Stromsammelschiene 4 werden keinerlei Werkzeuge benötigt. Handelt es sich bei der Anschlussklemme 13 um eine Rahmenklemme 13, wird zum Festschrauben beispielsweise ein Schraubenzieher durch den Monteur betätigt. Handelt es sich bei der Anschlussklemme 13 um eine Federzugsklemme bzw. Push-in-Klemme, wird zum Anschließen eines elektrischen Kabels an die Schaltvorrichtung 1 kein Werkzeug benötigt. Bei der in Fig. 1 dargestellten Ausführungsform dient die Schaltvorrichtung 1 zum Schalten eines elektrischen Bauelementes 10 in einen Strompfad. Bei einer alternativen Ausführungsform können durch Betätigen der Halteeinrichtung 11 gleichzeitig mehrere elektronische Bauelemente 10 parallel in einen oder verschiedene Strompfade geschaltet werden. Hierbei kann die schwenkbare Halteeinrichtung 11 symmetrisch derart ausgeformt sein, dass sie nur eine bestimmte Art von elektronischen Bauelementen 10 aufnehmen kann. Hierdurch können Verwechslungen beim Einsetzen von Bauelementen vermieden werden. Die Abmessungen des einzusetzenden Bauelementes 10 entspricht der Größe der geometrischen Ausnehmung der schwenkbaren Halteeinrichtung 11.

Bei Auftreten eines Überstromes kann beispielsweise eine eingesetzte Schmelzsicherung 10 schmelzen, so dass der Ohm'sehe Widerstand in den Strompfad sehr hoch wird und den Stromfluss unterbindet. Die durchgebrannte Schmelzsicherung wird dann ausgetauscht, nachdem die schwenkbare Halteeinrichtung 11 im Uhrzeigersinn um die Achse A gedreht worden ist. Bei einer möglichen Ausführungsform weist die Schaltvorrichtung 1 eine Anzeigeeinrichtung auf, die ein Schmelzen der Sicherung 10 anzeigt und somit einen Monteur darüber informiert, dass die Sicherung 10 ausgetauscht werden muss.

Fig. 4 zeigt ein Blockschaubild einer erfindungsgemäßen Photovoltaikanlage 18, welche Schaltvorrichtungen 1 zum Schalten elektronischer Bauelemente 10 verwendet. Die Photovoltaikanlage 18 weist mehrere Photovoltaik-Modul-Stränge 19-1, 19-2, 19-n auf, die jeweils mehrere seriell verschaltete Photovoltaik-Module 20, 21, 22 aufweisen. Bei dem in Fig. 4 dargestellten Ausführungsbeispiels weist jeder Photovoltaik-Modul-Strang 19-i jeweils drei verschaltete Photovoltaik-Module 20, 21, 22 auf. Die Anzahl der seriell verschalteten Photovoltaik-Module kann variieren, beispielsweise kann auch eine Vielzahl von Photovoltaik-Modulen 20, 21, 22 seriell in einem Photovoltaik-Modul-Strang 19-i verschaltet sein. Die Photovoltaik-Module erzeugen bei Lichteinstrahlung, insbesondere bei Sonnenlicht, einen elektrischen Gleichstrom DC. Wie in Fig. 4 dargestellt, wird jedes Photovoltaik-Modul 19-i über Schaltvorrichtungen 1 an zwei Knoten 23, 24 geschaltet, die als Summenstromknoten dienen. Über die Schaltvorrichtungen 1 können jeweils elektrische Bauelemente 10 in den Strompfad manuell geschaltet werden. Alternativ kann das Schalten der Schaltvorrichtungen 1 auch elektronisch gesteuert erfolgen. Die Photovoltaik-Modul-Stränge 19-i sind an Anschlussklemmen 13 der Schaltvorrichtungen 1 angeschlossen. Die Schaltvorrichtungen 1 sitzen auf Stromsammelschienen 4-1, 4-2, welche die Photovoltaik-Module 9-1 nach Einlegen und Schalten des elektrischen Bauelementes 10 in den Strompfad mit den Knoten 23, 24 elektrisch leitend verbinden. Die Knoten 23, 24 bilden Summenstromknoten. An dem Knoten 23 wird, wie in Fig. 4 dargestellt, ein Summenstrom I-1 + I-2 gebildet, der über eine Hauptsicherung 10 an einen Wechselrichter 25 fließt, welcher den Summenstrom, bei dem es sich um einen Gleichstrom DC handelt, in einen Wechselstrom AC umwandelt. Der erzeugte Wechselstrom AC wird über einen Anschluss 26 in ein Stromversorgungsnetz eingespeist. Die Stromsammelschienen 4-1, 4-2 können über die Hauptsicherungen an die Überspannungsschutzeinrichtungen 27-1, 27-2 angeschlossen sein, wie in Fig. 4 dargestellt. Wie man aus Fig. 4 erkennen kann, kann auf den Stromsammelschienen 4-1, 4-2 eine Vielzahl von Schaltvorrichtungen 1 in einfacher Weise aufgerastet werden, ohne dass ein Monteur zu einem Werkzeug oder dergleichen greifen muss, um die Montage vorzunehmen. Hierdurch wird der Gesamtaufwand zur Montage der Photovoltaikanlage 18 erheblich vermindert. Zudem wird sichergestellt, dass keine Kontaktierungsprobleme bzw. fehlerhafte Kontaktierungen aufgrund von Montagefehlern auftreten und alle Photovoltaik-Module 19-1 den von ihnen generierten Gleichstrom an den Wechselstromrichter 25 liefern. Bei der in Fig. 4 dargestellten Ausführungsform sind zwei Sicherungen 10 an jeden Photovoltaik-Modul-Strang 19-i angeschlossen, um die Leitungen bzw. die Photovoltaik-Module vor Schäden aufgrund von Überstrom zu schützen. Die Sicherungen 10 isolieren zudem einen beschädigten Photovoltaik-Modul-Strang, insbesondere bei einem dort aufgetretenen Kurzschluss, so dass die übrige Photovoltaikanlage 18 weiterhin ohne Beeinträchtigung elektrisch Strom erzeugen kann. Bei der in Fig. 4 dargestellten Photovoltaikanlage 18 kann eine Vielzahl von Schaltvorrichtungen 1 und eine entsprechende Anzahl von Photovoltaik-Modul-Strängen 19-i vorgesehen werden. Fig. 4 zeigt ein mögliches Anwendungsbeispiel für eine erfindungsgemäße Schaltvorrichtung 1 in einer erfindungsgemäßen Photovoltaikanlage 18. Die erfindungsgemäße Schaltvorrichtung 1 ist nicht auf diesen Anwendungsfall beschränkt, sondern kann vielseitig in verschiedenen Anlagen eingesetzt werden, bei der elektrische oder elektronische Bauelemente 10 in einen Strompfad zu verschalten sind. Die elektrischen Bauelemente 10 sind nicht auf Sicherungsbauelemente beschränkt, sondern können auch andere elektrische bzw. elektronische Bauelemente umfassen, beispielsweise Widerstände, Kondensatoren oder Spulen. Die erfindungsgemäße Schaltvorrichtung 1 weist vorzugsweise eine manuell betätigbare schwenkbare Halteeinrichtung 11 auf, wie in Fig. 1 dargestellt. Alternativ kann die Betätigung der Halteeinrichtung 11 auch elektronisch gesteuert erfolgen. Das erfolgreiche Schließen eines Strompfades über ein elektrisches Bauelement 10 kann darüber hinaus über eine Anzeigeeinrichtung angezeigt werden und/oder über eine Leitung an eine Steuereinrichtung gemeldet werden. Auch das Schmelzen einer Schmelzsicherung 10 bzw. die Zerstörung eines eingelegten Bauelementes 10 kann bei einer möglichen Ausführungsform elektronsich gemeldet oder einem Monteur angezeigt werden.

### Bezugszeichenliste

- 1: Schaltvorrichtung
- 2: Gehäuse
- 3A, 3B: Arretiereinrichtung
- 4: Stromsammelschiene
- 5A, 5B: Zunge
- 6A, 6B, 7A, 7B: Rippen
- 8A, 8B: Rastabschnitt
- 9A, 9B: Betätigungsabschnitt
- 10: Bauelement
- 11: Sicherungshalter / Halteeinrichtung
- 12: Betätigungsabschnitt
- 13: Anschlussklemme
- 14: Klemmschraube
- 15: Öffnung
- 16: Federkontakt
- 17: Feder
- 18: Photovoltaikanlage
- 19: Photovoltaik-Modul-Strang
- 20, 21, 22: Photovoltaik-Module
- 23, 24: Summenknoten
- 25: Wechselrichter
- 26: Netzanschluss
- 27: Überspannungsschutzeinrichtung

## Patentansprüche

1. Schaltvorrichtung (1) zum Schalten eines elektrischen Bauelementes (10) in einen Strompfad, wobei die Schaltungsvorrichtung (1) aufweist:
- ein Gehäuse (2) mit einer Arretiereinrichtung (3) zum Aufrasten des Gehäuses (2) auf einer Stromsammelschiene (4), wobei die Arretiereinrichtung (3) beweglich ausgebildet ist zum Aufrasten des Gehäuses (2) auf der Stromsammelschiene (4) und zum Lösen des Gehäuses (2) von der Stromsammelschiene (4);
- eine schwenkbaren Halteeinrichtung (11), in welcher das elektrische Bauelement (10) einsetzbar und durch Schwenken der Halteeinrichtung (11) in den Strompfad schaltbar ist;
**gekennzeichnet durch**
- eine einzige Anschlussklemme (13), die über das in den Strompfad geschaltete elektrische Bauelement (10) direkt mit mindestens einem am Gehäuse (2) vorgesehenen Federkontakt (16) verbunden ist, welcher in einem aufgerasteten Zustand des Gehäuses (2) an der Stromsammelschiene (4) anliegt.

2. Schaltvorrichtung (1) nach Anspruch 1, wobei eine Feder (17) den Federkontakt (16) in dem aufgerasteten Zustand des Gehäuses (2) der Schaltvorrichtung (1) gegen die Stromsammelschiene (4) drückt.

3. Schaltvorrichtung (1) nach Anspruch 2, wobei die Feder (17) eine Blattfeder ist.

4. Schaltvorrichtung (1) nach einem der vorangehenden Ansprüche 1 bis 3, wobei der Federkontakt (16) L-förmig oder U-förmig ist.

5. Schaltvorrichtung (1) nach einem der vorangehenden Ansprüche 1 bis 4, wobei die Anschlussklemme (13) eine Rahmenklemme oder eine Federzugsklemme ist.

6. Schaltvorrichtung (1) nach einem der vorangehenden Ansprüche 1 bis 5, wobei in die Halteeinrichtung (11) als elektrisches Bauelement (10) eine Schmelzsicherung einsetzbar ist.

7. Schaltvorrichtung (1) nach einem der vorangehenden Ansprüche 1 bis 6, wobei die Arretiereinrichtung (3) mindestens eine Zunge (5) aufweist, die durch mindestens zwei im Wesentlichen parallel verlaufende Rippen (6, 7) an das Gehäuse (2) der Schaltvorrichtung (1) angeformt ist.

8. Schaltvorrichtung (1) nach einem der vorangehenden Ansprüche 1 bis 7, wobei der Federkontakt (16) in dem aufgerasteten Zustand des Gehäuses (2) an einen Seitenabschnitt oder an einer Oberseite der Stromsammelschiene (4) anliegt.

9. Schaltvorrichtung (1) nach einem der vorangehenden Ansprüche 1 bis 8, wobei der Federkontakt (16) aus einem federnden leitfähigen Material besteht.

10. Schaltvorrichtung (1) nach einem der vorangehenden Ansprüche 1 bis 9, wobei an die Anschlussklemme (13) ein Photovoltaik-Modul-Strang (19) von seriell verschalteten Photovoltaik-Modulen (20, 21, 22) anschließbar ist, die bei Lichteinstrahlung einen elektrischen Gleichstrom erzeugen.

11. Photovoltaikanlage (18) mit mehreren Photovoltaik-Modul-Strängen (19), die jeweils seriell verschaltete Photovoltaik-Module (20, 21, 22) aufweisen, die bei Lichteinstrahlung einen elektrischen Gleichstrom erzeugen, wobei jeder Photovoltaik-Modul-Strang (19) an einer Anschlussklemme einer zugehörigen Schaltvorrichtung (1) nach einem der vorangehenden Ansprüche 1 bis 10 angeschlossen ist.

12. Photovoltaikanlage (18) nach Anspruch 11, wobei die Stromsammelschiene (4) einen Summenstromknoten für die Photovoltaik-Modul-Strängen (19) bildet, die jeweils über die Schaltvorrichtung (1) mit der Stromsammelschiene (4) verbunden sind, so dass auf der Stromsammelschiene (4) die erzeugten Gleichströme der Photovoltaik-Modul-Stränge (19) zu einem Summenstrom aufsummiert werden

13. Photovoltaikanlage (18) nach Anspruch 11 oder 12, wobei die Stromsammelschiene (4) an einen Wechselrichter (25) angeschlossen ist, welcher einen über die Stromsammelschiene (4) fließenden Summen-Gleichstrom, welcher die Summe aller durch die Photovoltaik-Modul-Stränge (19) erzeugten Gleichströme bildet, in einen Wechselstrom umwandelt.

14. Photovoltaikanlage (18) nach einem der vorangehenden Ansprüche 11 oder 12, wobei die Stromsammelschiene (4) an einem Überspannungsschutz (27) angeschlossen ist.

## Claims

1. Switching device (1) for switching an electrical component (10) into a current path, the switching device (1) having:
- a housing (2) comprising a locking device (3) for latching the housing (2) onto a busbar (4), the locking device (3) being formed movably for latching the housing (2) on the busbar (4) and for releasing the housing (2) from the busbar (4);
- a pivotable holding device (11), into which the electrical component (10) can be inserted and switched into the current path by pivoting the holding device (11) ;
**characterised by**
- a single terminal (13), which is directly connected, via the electrical component (10) switched into the current path, to at least one spring contact (16), which is provided on the housing (2) and which, in a latched state of the housing (2), is positioned on the busbar (4).

2. Switching device (1) according to claim 1, wherein a spring (17) presses the spring contact (16) against the busbar (4) in the latched state of the housing (2) of the switching device (1).

3. Switching device (1) according to claim 2, wherein the spring (17) is a leaf spring.

4. Switching device (1) according to any of preceding claims 1 to 3, wherein the spring contact (16) is L-shaped or U-shaped.

5. Switching device (1) according to any of preceding claims 1 to 4, wherein the terminal (13) is a box terminal or a spring-type terminal.

6. Switching device (1) according to any of preceding claims 1 to 5, wherein a fuse can be inserted into the holding device (11) as an electrical component (10).

7. Switching device (1) according to any of preceding claims 1 to 6, wherein the locking device (3) has at least one tongue (5), which is formed integrally on the housing (2) of the switching device (1) by at least two ribs (6, 7) which extend substantially mutually parallel.

8. Switching device (1) according to any of preceding claims 1 to 7, wherein the spring contact (16) is positioned on a side portion or upper face of the busbar (4) in the latched state of the housing (2).

9. Switching device (1) according to any of claims 1 to 8, wherein the spring contact (16) consists of a resilient, conductive material.

10. Switching device (1) according to any of preceding claims 1 to 9, wherein a photovoltaic module string (19) of photovoltaic modules (20, 21, 22), which are connected in series and generate an electrical direct current when irradiated with light, is connectable to the terminal (13).

11. Photovoltaic system (18) comprising a plurality of photovoltaic module strings (19) which each have photovoltaic modules (20, 21, 22), which are connected in series in each case and generate an electrical direct current when irradiated with light, each photovoltaic module string (19) being connected to a terminal of an associated switching device (1) according to any of preceding claims 1 to 10.

12. Photovoltaic system (18) according to claim 11, wherein the busbar (4) forms a sum current node for the photovoltaic module strings (19), which are in each case connected to the busbar (4) via the switching device (1), in such a way that on the busbar (4) the generated direct currents of the photovoltaic module strings (19) are summed to form a sum current.

13. Photovoltaic system (18) according to either claim 11 or claim 12, wherein the busbar (4) is connected to an inverter (25), which converts a sum direct current, which flows over the busbar (4) and forms the sum of all direct currents generated by the photovoltaic module strings (19), into an alternating current.

14. Photovoltaic system (18) according to either of preceding claims 11 and 12, wherein the busbar (4) is connected to a surge protector (27).

## Revendications

1. Dispositif de commutation (1) pour commuter un composant électrique (10) dans un trajet de courant, le dispositif de commutation (1) présentant :
- un boîtier (2) avec un moyen de verrouillage (3) pour encliqueter le boîtier (2) sur une barre collectrice de courant (4), le moyen de verrouillage (3) étant conçu mobile pour encliqueter le boîtier (2) sur la barre collectrice de courant (4) et pour libérer le boîtier (2) de la barre collectrice de courant (4) ;
- un moyen de maintien pivotant (11), dans lequel le composant électrique (10) peut être inséré et commuté dans le trajet de courant par pivotement du moyen de maintien (11) ;
**caractérisé par**
- une seule borne de connexion (13) qui est reliée directement, par l'intermédiaire du composant électrique (10) commuté dans le trajet de courant, à au moins un contact à ressort (16) prévu sur le boîtier (2), lequel contact à ressort (16) s'applique contre la barre collectrice de courant (4) dans un état encliqueté du boîtier (2).

2. Dispositif de commutation (1) selon la revendication 1, dans lequel un ressort (17) presse le contact à ressort (16) contre la barre collectrice de courant (4) dans l'état encliqueté du boîtier (2) du dispositif de commutation (1).

3. Dispositif de commutation (1) selon la revendication 2, dans lequel le ressort (17) est un ressort à lame.

4. Dispositif de commutation (1) selon l'une des revendications 1 à 3 précédentes, dans lequel le contact à ressort (16) est en forme de L ou de U.

5. Dispositif de commutation (1) selon l'une des revendications 1 à 4 précédentes, dans lequel la borne de connexion (13) est une borne à cage ou une borne à ressort.

6. Dispositif de commutation (1) selon l'une des revendications 1 à 5 précédentes, dans lequel un fusible peut être inséré dans le moyen de maintien (11) en tant que composant électrique (10).

7. Dispositif de commutation (1) selon l'une des revendications 1 à 6 précédentes, dans lequel le moyen de verrouillage (3) présente au moins une languette (5) qui est formée sur le boîtier (2) du dispositif de commutation (1) par au moins deux nervures (6, 7) s'étendant sensiblement parallèlement.

8. Dispositif de commutation (1) selon l'une des revendications 1 à 7 précédentes, dans lequel le contact à ressort (16) s'applique contre une partie latérale ou contre un côté supérieur de la barre collectrice de courant (4) dans l'état encliqueté du boîtier (2).

9. Dispositif de commutation (1) selon l'une des revendications 1 à 8 précédentes, dans lequel le contact à ressort (16) est constitué d'un matériau conducteur élastique.

10. Dispositif de commutation (1) selon l'une des revendications 1 à 9 précédentes, dans lequel une chaîne de modules photovoltaïques (19) de modules photovoltaïques (20, 21, 22) montés en série, qui génèrent un courant électrique continu lorsqu'ils sont exposés à un rayonnement lumineux, peut être connectée à la borne de connexion (13).

11. Installation photovoltaïque (18) comportant plusieurs chaînes de modules photovoltaïques (19) qui présentent chacune des modules photovoltaïques (20, 21, 22) montés en série, qui génèrent un courant électrique continu lorsqu'ils sont exposés à un rayonnement lumineux, chaque chaîne de modules photovoltaïques (19) étant connectée à une borne de connexion d'un dispositif de commutation associé (1) selon l'une des revendications 1 à 10 précédentes.

12. Installation photovoltaïque (18) selon la revendication 11, dans laquelle la barre collectrice de courant (4) forme un nœud de courant total pour les chaînes de modules photovoltaïques (19) qui sont chacune reliées à la barre collectrice de courant (4) par l'intermédiaire du dispositif de commutation (1), de sorte que les courants continus générés par les chaînes de modules photovoltaïques (19) sont totalisés en un courant total sur la barre collectrice de courant (4).

13. Installation photovoltaïque (18) selon la revendication 11 ou 12, dans laquelle la barre collectrice de courant (4) est connectée à un onduleur (25) qui convertit en courant alternatif un courant continu total qui circule via la barre collectrice de courant (4) et qui constitue la somme de tous les courants continus générés par les chaînes de modules photovoltaïques (19).

14. Installation photovoltaïque (18) selon l'une des revendications 11 ou 12 précédentes, dans laquelle la barre collectrice de courant (4) est connectée à un moyen de protection contre les surtensions (27).
